# FASCICULE DE BREVET EUROPEEN

(11) **EP 4 264 659 B1**
(45) Date de publication et mention de la délivrance du brevet: **01.01.2025**
(21) Numéro de dépôt: 21835348.0
(22) Date de dépôt: 29.11.2021
(51) Int. Cl.: H01L 21/18, H01L 21/02, H01L 21/322

(54) **PROCEDE DE FABRICATION D'UNE STRUCTURE SEMI-CONDUCTRICE COMPRENANT UNE ZONE D'INTERFACE INCLUANT DES AGGLOMERATS**
VERFAHREN ZUR HERSTELLUNG EINER HALBLEITERSTRUKTUR MIT EINEM AGGLOMERAT-HALTIGEN GRENZFLÄCHENBEREICH
METHOD FOR PRODUCING A SEMICONDUCTOR STRUCTURE COMPRISING AN INTERFACE REGION INCLUDING AGGLOMERATES

(30) Priorité: 15.12.2020 FR 2013294
(43) Date de publication de la demande: 25.10.2023
(73) Titulaire: Commissariat à l'Energie Atomique et aux Energies Alternatives, 75015 Paris (FR); SOITEC, 38190 Bernin (FR)
(72) Inventeur: GAUDIN, Gweltaz, 38190 Bernin (FR); RADU, Ionut, 38190 Bernin (FR); FOURNEL, Franck, 38000 Grenoble (FR); WIDIEZ, Julie, 38000 Grenoble (FR); LANDRU, Didier, 38190 Bernin (FR)
(74) Mandataire: IP Trust
(86) Numéro de dépôt international: PCT/FR2021/052124
(87) Numéro de publication internationale: WO 2022/129726

(56) Documents cités:
- FR-A1- 2 798 224
- FR-A1- 3 006 236
- FR-B1- 2 798 224
- US-A1- 2015 303 316

## Description

### DOMAINE DE L'INVENTION

La présente invention concerne le domaine des matériaux semi-conducteurs pour composants microélectroniques. Elle concerne en particulier un procédé de fabrication d'une structure comprenant une couche utile semi-conductrice et un substrat support semi-conducteur, assemblés au niveau d'une zone d'interface dans laquelle coexistent côte à côte des régions de contact direct entre la couche et le substrat support, et des agglomérats comprenant un matériau semi-conducteur, autre que le (ou les) matériau(x) semi-conducteur(s) de la couche et du substrat support.

### ARRIERE PLAN TECHNOLOGIQUE DE L'INVENTION

Il est habituel de former une structure semi-conductrice par report d'une couche utile semi-conductrice, de faible épaisseur et de haute qualité cristalline, sur un substrat support semi-conducteur de moindre qualité cristalline. Une solution de transfert de couche mince bien connue est le procédé Smart Cut^{™}, basé sur une implantation d'ions légers et sur un assemblage, par collage direct, au niveau d'une interface de collage. En plus des avantages économiques liés à la rationalisation du matériau de haute qualité de la couche utile, la structure semi-conductrice peut également procurer des propriétés avantageuses par exemple liées à la conductivité thermique, électrique ou la compatibilité mécanique du substrat support.

Dans le domaine de l'électronique de puissance par exemple, il peut être en outre avantageux d'établir une conduction électrique entre la couche utile et le substrat support, de manière à former des composants verticaux. Par exemple dans le cas d'une structure comprenant une couche utile en carbure de silicium monocristallin et un substrat support en carbure de silicium de moindre qualité (monocristallin ou poly-cristallin), l'interface de collage doit présenter une résistivité aussi faible que possible, préférentiellement inférieure à 1 mohm.cm², voire inférieure à 0,1 mohm.cm².

Dans d'autres domaines, même si une haute conductivité électrique verticale n'est pas requise, un contact direct entre la couche utile et le substrat support est nécessaire pour garantir une continuité électrique et/ou thermique, et/ou une très forte cohésion ou tenue mécanique.

Certaines solutions de l'état de la technique proposent de réaliser un collage, par adhésion moléculaire, semi-conducteur sur semi-conducteur, entre la couche utile et le substrat support. Il est alors requis de gérer les couches d'oxyde natif à l'interface de collage, qui empêchent un contact direct entre la couche utile et le substrat support. On peut notamment réaliser des collages de type hydrophobes, mais à partir desquels il reste difficile d'obtenir une bonne qualité d'interface.

F.Mu et al (ECS Transactions, 86 (5) 3-21, 2018) mettent en oeuvre un collage direct, après activation des surfaces à assembler par bombardement d'argon (SAB pour « Surface Activation bonding ») : un tel traitement préalable au collage génère une très forte densité de liaisons pendantes, lesquelles favorisent la formation de liaisons covalentes à l'interface d'assemblage, et donc une forte énergie de collage. Cette méthode présente néanmoins l'inconvénient de générer une couche amorphe, au niveau des surfaces assemblées, qui impacte défavorablement notamment la conduction électrique verticale entre la couche mince et le substrat support. Pour pallier ce problème, un fort dopage desdites surfaces est proposé en particulier dans le document EP3168862. D'autres modes de collage de deux substrats sont décrits en FR 2 798 224 A1, US 2015/303316 A1 et FR 3 006 236 A1."

### OBJET DE L'INVENTION

La présente invention concerne une solution alternative à celles de l'état de la technique, et vise à remédier à tout ou partie des inconvénients précités. Elle concerne en particulier un procédé de fabrication d'une structure comprenant une couche utile semi-conductrice et un substrat support semi-conducteur, assemblés au niveau d'une zone d'interface comportant des régions de contact direct entre couche et substrat support, et des agglomérats comprenant un matériau semi-conducteur différent de celui (ou ceux) de la couche et du substrat support.

### BREVE DESCRIPTION DE L'INVENTION

L'invention concerne un procédé de fabrication d'une structure semi-conductrice comprenant les étapes suivantes :
a) la fourniture d'une couche utile en un matériau semi-conducteur présentant une face libre à assembler,
b) la fourniture d'un substrat support en un matériau semi-conducteur présentant une face libre à assembler,
c) le dépôt d'un film composé d'un matériau semi-conducteur différent de celui ou ceux de la couche utile et du substrat support, présentant une épaisseur inférieure à 50 nm, sur la face libre à assembler de la couche utile et/ou sur la face libre à assembler du substrat support,
d) la formation d'une structure intermédiaire, comprenant un assemblage direct, le long d'une interface de collage s'étendant selon un plan principal, des faces libres à assembler respectivement de la couche utile et du substrat support, la structure intermédiaire comprenant un film encapsulé issu du ou des film(s) déposés lors de l'étape c),
e) le recuit de la structure intermédiaire à une température supérieure ou égale à une température critique, de manière à provoquer la segmentation du film encapsulé et à former la structure semi-conductrice comprenant une zone d'interface entre la couche utile et le substrat support, ladite zone d'interface comportant :
   - des régions de contact direct entre la couche utile et le substrat support, et
   - des agglomérats comprenant le matériau semi-conducteur du film, et présentant une épaisseur, selon un axe normal au plan principal, inférieure ou égale à 250nm ; les régions de contact direct et les agglomérats étant adjacents dans le plan principal.

Selon d'autres caractéristiques avantageuses et non limitatives de l'invention, prises seules ou selon toute combinaison techniquement réalisable :
- à l'étape a), la face libre à assembler de la couche utile comporte un oxyde natif et/ou, à l'étape b), la face libre à assembler du substrat support comporte un oxyde natif,
- à l'étape e), les agglomérats de la zone d'interface piègent l'oxygène issu du ou des oxyde(s) natif(s),
- l'étape a) comprend une implantation d'espèces légères dans un substrat donneur, pour former un plan fragile enterré qui délimite, avec une face avant du substrat donneur, la couche utile,
- l'étape a) comprend la formation du substrat donneur, par épitaxie d'une couche donneuse sur un substrat initial, l'implantation étant réalisée ultérieurement, dans la couche donneuse,
- l'étape d) comprend, après l'assemblage direct donnant lieu à un ensemble collé comprenant le substrat donneur et le substrat support, une séparation au niveau du plan fragile enterré, pour former d'une part la structure intermédiaire comprenant la couche utile, le film encapsulé et le substrat support, et d'autre part, le reste du substrat donneur,
- l'épaisseur du film déposé à l'étape c) est inférieure ou égale à 10nm, voire inférieure ou égale à 5 nm, voire inférieure ou égale à 3 nm, voire inférieure ou égale à 2nm,
- l'épaisseur du film déposé à l'étape c) est inférieure à 10nm, et les agglomérats présentent une épaisseur, selon un axe normal au plan principal, inférieure ou égale à 50nm,
- la température critique est comprise entre 500°C et 1800°C, selon la nature du matériau semi-conducteur du film et du (ou des) matériau(x) semi-conducteur(s) de la couche utile et du substrat support,
- le matériau semi-conducteur de la couche utile est le carbure de silicium et présente une structure monocristalline, poly-cristalline ou amorphe,
- le matériau semi-conducteur du substrat support est le carbure de silicium et présente une structure monocristalline, poly-cristalline ou amorphe,
- le matériau semi-conducteur du film est choisi parmi le silicium ou le germanium,
- les agglomérats présentent une épaisseur inférieure ou égale à 40 nm, voire inférieure ou égale à 30nm,
- les agglomérats se présentent sous la forme de premiers précipités comprenant le matériau semi-conducteur du film, de deuxièmes précipités comprenant le matériau semi-conducteur du film et de l'oxygène, et/ou de cavités tapissées d'un composé comprenant le matériau semi-conducteur du film et de l'oxygène,
- les deuxièmes précipités présentent une forme sensiblement triangulaire dans un plan transverse normal au plan principal,
- les agglomérats présentent des dimensions latérales, dans le plan principal, comprises entre 5nm et 500nm.

L'invention concerne également un composant électronique élaboré sur et/ou dans la couche utile d'une structure semi-conductrice issue du procédé de fabrication précité. La structure semi-conductrice comprend :
- la couche utile en un matériau semi-conducteur, s'étendant selon un plan principal,
- un substrat support en un matériau semi-conducteur,
- et une zone d'interface entre la couche utile et le substrat support, s'étendant parallèlement au plan principal, la zone d'interface comportant des régions de contact direct entre la couche utile et le substrat support, et des agglomérats comprenant un matériau semi-conducteur différent de celui ou ceux de la couche utile et du substrat support, et présentant une épaisseur, selon un axe normal au plan principal, inférieure ou égale à 250nm ; les régions de contact direct et les agglomérats étant adjacents dans le plan principal.

Selon une variante particulière, le composant comprend au moins un contact électrique sur et/ou dans le substrat support, au niveau d'une face arrière de la structure semi-conductrice pour une application de puissance.

### BREVE DESCRIPTION DES FIGURES

D'autres caractéristiques et avantages de l'invention ressortiront de la description détaillée de l'invention qui va suivre en référence aux figures annexées sur lesquelles :

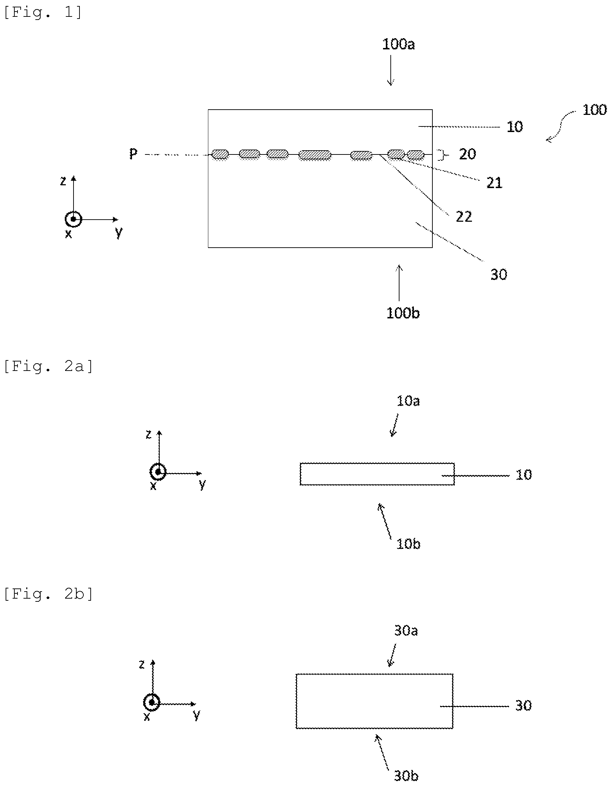

[Fig. 1] La figure 1 présente une structure semi-conductrice conforme à l'invention ;
[Fig. 2a]
[Fig. 2b]
[Fig. 2c]
[Fig. 2d]

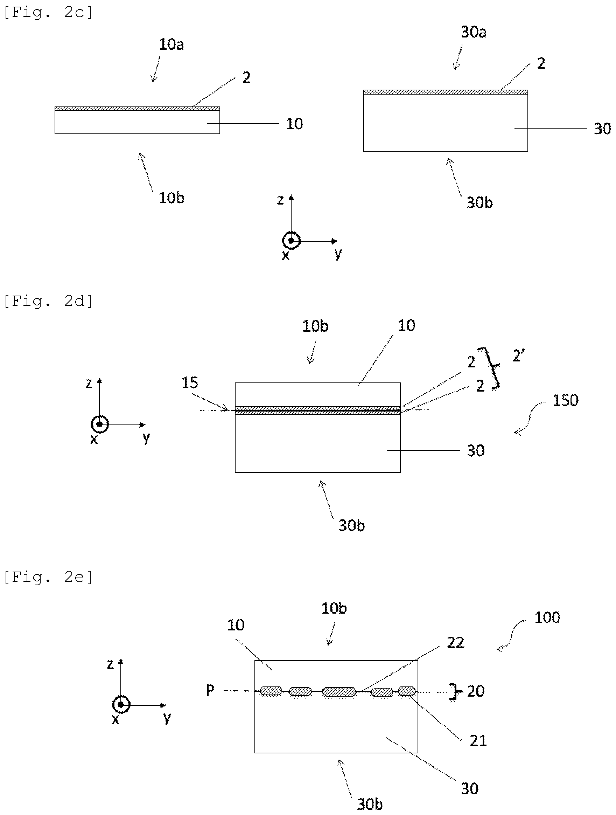

[Fig. 2e] Les figures 2a à 2e présentent des étapes d'un procédé de fabrication conforme à l'invention ;
[Fig. 3a]
[Fig. 3b]
[Fig. 3c]

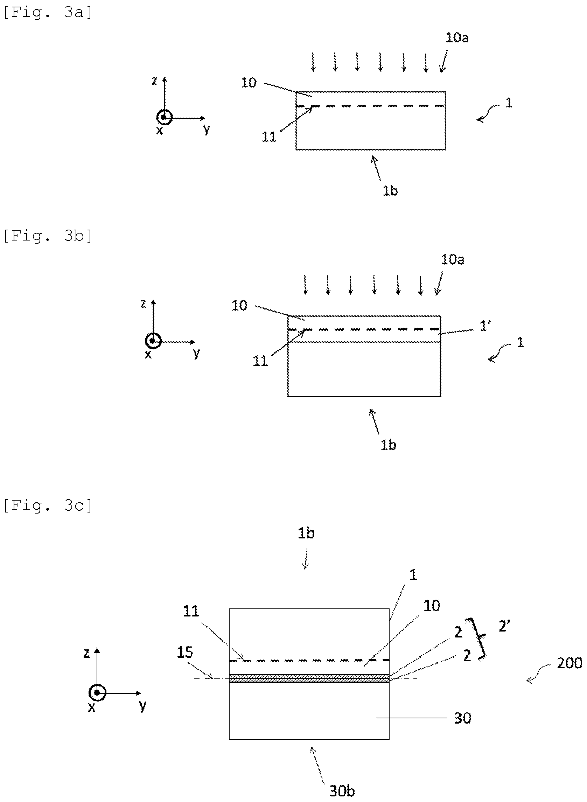

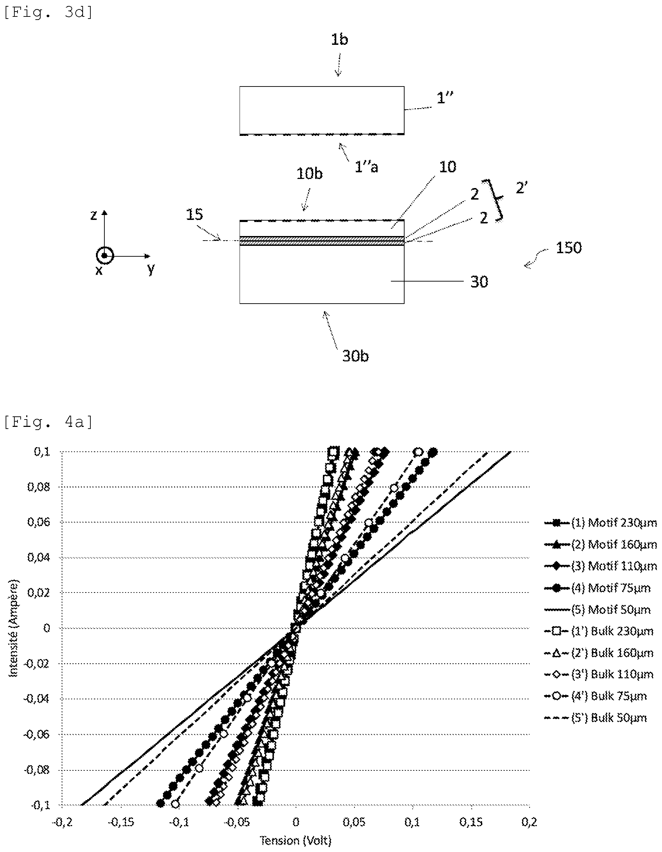

[Fig. 3d] Les figures 3a à 3d présentent des variantes d'étapes d'un procédé de fabrication conforme à l'invention ;
[Fig.4a]

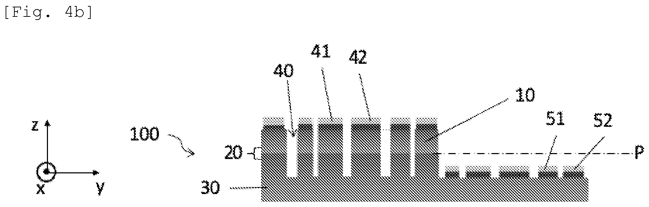

[Fig.4b] Les figures 4a et 4b présentent respectivement, un graphe I(V) (courant en fonction de la tension) comparant les caractéristiques électriques d'une zone d'interface d'une structure semi-conductrice conforme à l'invention et celles d'un substrat massif, pour différentes tailles de motifs d'électrodes, et la disposition des électrodes sur ladite structure pour faire une telle mesure.

Les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas respectées sur les figures.

### DESCRIPTION DETAILLEE DE L'INVENTION

L'invention concerne un procédé de fabrication d'une structure semi-conductrice 100 comprenant une couche utile 10 en matériau semi-conducteur monocristallin, un substrat support 30 en matériau semi-conducteur, et une zone d'interface 20 entre la couche utile 10 et le substrat support 30 (figure 1). Comme la couche utile 10, la zone d'interface 20 s'étend parallèlement au plan principal (x,y).

Avantageusement, et comme cela est habituellement le cas dans le domaine de la microélectronique, la structure semi-conductrice 100 se présente sous la forme d'une plaquette circulaire de diamètre compris entre 100mm et 450mm, et d'épaisseur totale typiquement comprise entre 300 microns et 1000 microns. On comprend que, dans ce cas, le substrat support 30 et la couche utile 10 présentent également une telle forme circulaire. Les faces (circulaires) avant 100a et arrière 100b de la plaquette s'étendent parallèlement au plan principal (x,y).

De nombreux types de structure semi-conductrice 100 permettant une conduction électrique verticale ou un contact direct entre la couche utile 10 et le substrat support 30 peuvent présenter un intérêt pour des applications microélectroniques : la nature des matériaux composant la couche utile 10 et le substrat support 30 peut donc être très variée.

A titre d'exemple, le matériau semi-conducteur de la couche utile 10 peut être choisi parmi le carbure de silicium, le silicium, le nitrure de gallium, l'arséniure de gallium, le phosphure d'indium et les alliages silicium-germanium. En général, l'élaboration de composants sur la couche utile 10 nécessite une haute qualité cristalline de ladite couche 10 : elle est donc préférentiellement choisie monocristalline, avec un grade de qualité, un type et un niveau de dopage adapté à l'application visée. Alternativement, la couche utile 10 peut bien sûr présenter une structure poly-cristalline ou amorphe.

Toujours à titre d'exemple, le matériau semi-conducteur du substrat support 30 peut être choisi parmi le carbure de silicium, le silicium, le nitrure de gallium, l'arséniure de gallium, le phosphure d'indium et les alliages silicium-germanium. Il présente préférentiellement un niveau de qualité moindre, essentiellement pour des raisons économiques, et une structure monocristalline, poly-cristalline ou amorphe. Son type et son niveau de dopage sont choisis pour répondre à l'application visée.

Le procédé de fabrication comprend en premier lieu une étape a) de fourniture de la couche utile 10 en matériau semi-conducteur, préférentiellement monocristallin (figure 2a). A cette étape a), la couche utile 10 présente une face libre 10a destinée à être assemblée, lors d'une étape ultérieure du procédé, également appelée face avant 10a ; elle présente également une face arrière 10b opposée à sa face avant 10a.

Selon un mode de mise en oeuvre avantageux, la couche utile 10 est issue du transfert d'une couche superficielle d'un substrat donneur 1, en particulier un transfert de couche basé sur le procédé Smart Cut^{™}.

L'étape a) peut ainsi comprendre une implantation d'espèces légères, par exemple hydrogène, hélium ou une combinaison de ces deux espèces, dans un substrat donneur 1, pour former un plan fragile enterré 11 qui délimite, avec une face avant 10a du substrat donneur 1, la couche utile 10 (figure 3a).

Selon une variante de ce mode de mise en oeuvre, l'étape a) comprend la formation du substrat donneur 1, par épitaxie d'une couche donneuse 1' sur un substrat initial, préalablement à l'implantation des espèces légères (figure 3b). Cette variante permet de former une couche donneuse 1' présentant les caractéristiques structurelles et électriques requises pour l'application visée. En particulier, une excellente qualité cristalline peut être obtenue par épitaxie, et un dopage in situ de la couche donneuse 1' peut être précisément contrôlé. L'implantation d'espèces légères, pour former le plan fragile enterré 11, est ensuite réalisée dans la couche donneuse 1'.

Alternativement, la couche utile 10, fournie à l'étape a), peut bien sûr être formée à partir d'autres techniques de transfert de couches minces connues.

Le procédé de fabrication selon l'invention comprend ensuite une étape b) de fourniture d'un substrat support 30 en matériau semi-conducteur (figure 2b). Le substrat support 30 présente une face libre 30a destinée à être assemblée lors d'une étape ultérieure du procédé, également appelée face avant 30a ; il présente également une face arrière 30b.

La couche utile 10 et le substrat support 30 pourront être formés d'un ou plusieurs matériaux choisis parmi ceux évoqués précédemment.

Le procédé de fabrication comprend ensuite une étape c) de dépôt d'un film 2 en un matériau semi-conducteur (dit deuxième matériau), sur la face libre à assembler 10a de la couche utile 10 ou sur la face libre à assembler 30a du substrat support 30 ou encore, comme cela est illustré sur la figure 2c, sur les deux faces libres à assembler 10a,30a. Le deuxième matériau est différent du (ou des) matériau(x) semi-conducteur(s) de la couche utile 10 et du substrat support 30.

Préférentiellement, le deuxième matériau est choisi pour son affinité particulière avec l'oxygène ; en outre, il n'est pas un composé de plusieurs éléments et, en réagissant avec l'oxygène, il doit générer un composé solide et non gazeux.

Le deuxième matériau doit pouvoir être déposé en couche extrêmement mince et être compatible avec une ligne de fabrication de composants microélectroniques (« front end of line »). Il pourra notamment être choisi parmi le silicium, le germanium, etc., en fonction de la nature de la couche utile 10 et du substrat support 30.

Le film 2 présente une épaisseur inférieure à 50 nm, préférentiellement inférieure ou égale à 10nm, inférieure ou égale à 8 nm, inférieure ou égale à 5 nm, voire inférieure ou égale à 3 nm, voire encore inférieure ou égale à 2nm. Par exemple, le film 2 déposé pourra présenter une épaisseur de l'ordre de 0,5 nm, 1 nm, 2 nm, 3 nm, 4 nm, 5 nm, 8 nm, 9 nm, 10 nm, 11 nm, 12 nm, 13 nm, 15 nm, 20 nm, 30 nm ou 40 nm.

Notons que lorsqu'un film 2 est déposé sur les deux faces libres 10a,30a, l'épaisseur totale déposée, c'est-à-dire la somme des épaisseurs de film 2 déposé sur l'une et l'autre faces libres 10a,30a est préférentiellement inférieure à 50 nm, préférentiellement inférieure ou égale à 10nm, inférieure ou égale à 8 nm, voire inférieure ou égale à 5 nm. L'épaisseur totale de film 2 déposé est impérativement maintenue faible, de manière à autoriser une segmentation du film sous forme d'agglomérats 21, à une étape ultérieure du procédé.

Le dépôt du film 2 est opéré sous atmosphère contrôlée. Selon la nature du film 2 déposé, l'étape c) est réalisée à basses températures voire température ambiante, avantageusement par une technique de dépôt chimique en phase vapeur connue (assisté par plasma : PECVD, à pression sous-atmosphérique : LPCVD), ou une technique de pulvérisation utilisant, pour bombarder la cible, un élément neutre ou dont la présence résiduelle dans le film déposé n'est pas gênante (Ar, Si, N...) .

Le procédé de fabrication comprend ensuite une étape d) de formation d'une structure intermédiaire 150, laquelle étape comprend un assemblage des faces libres à assembler 10a, 30a respectivement de la couche utile 10 et du substrat support 30, au niveau d'une interface de collage 15 s'étendant selon le plan principal (x, y) (figure 2d).

Cet assemblage direct est préférentiellement effectué par collage par adhésion moléculaire, consistant en la mise en contact des faces à assembler 10a,30a sans ajout de matière adhésive intermédiaire. Il pourra s'agir d'un collage direct entre la couche utile 10 et le film 2, lorsque ce dernier a été uniquement déposé sur le substrat support 30, ou d'un collage direct entre le substrat support 30 et le film 2, lorsque ce dernier a été uniquement déposé sur la couche utile 10, ou encore d'un collage direct entre deux films 2, lorsqu'ils ont été déposés sur la couche utile 10 et sur le substrat support 30. L'assemblage direct peut être opéré en atmosphère ambiante, ou sous une atmosphère contrôlée et en particulier sous un vide poussé, de l'ordre de 10⁻⁶Pa ou moins.

Optionnellement, le dépôt de l'étape c) et l'assemblage direct de l'étape d) sont enchaînés sans rupture du vide, in-situ ou dans un équipement multi-chambres. On citera à titre d'exemple l'équipement de collage par diffusion atomique (« Atomic Diffusion Bonding) BV7000 de la société Canon, dans lequel il est possible de réaliser successivement un dépôt et un collage direct, en maintenant une atmosphère contrôlée.

En référence au mode de mise en oeuvre avantageux illustré sur les figures 3a à 3d, l'étape d) comprenant l'assemblage direct de la face libre à assembler 10a de la couche utile 10 sur la face libre à assembler 30a du substrat support 30, donne lieu à un ensemble collé 200 incluant le substrat donneur 1, le substrat support 30, et l'interface de collage 15 (figure 3c). L'étape d) comprend en outre une séparation au niveau du plan fragile enterré 11, pour former d'une part la structure intermédiaire 150 comprenant la couche utile 10, le (ou les) film(s) 2 et le substrat support 30, et d'autre part, le reste du substrat donneur 1" (figure 3d). Une telle séparation peut s'effectuer au cours d'un traitement thermique capable de faire croître des cavités lenticulaires (« platelets ») et microfissures sous pression, induites par les espèces implantées, dans le plan fragile enterré 11. La séparation peut également être opérée par application d'une contrainte mécanique, ou encore par la combinaison de sollicitations thermiques et mécaniques, comme cela est bien connu en référence au procédé Smart Cut^{™}.

Des séquences de nettoyage, de lissage, de polissage ou de gravure de la face séparée 10b de la couche utile 10 et/ou de la face séparée 1" a du reste du substrat donneur 1" pourront être opérées de manière à restaurer une bonne qualité de surface, notamment en termes de rugosité, défectivité et autres contaminations.

Quel que soit le mode de mise en oeuvre du procédé, à l'issue de l'étape d), la structure intermédiaire 150 présente une face avant 10b du côté de la couche utile 10, une face arrière 30b du côté du substrat support 30, et un film encapsulé 2' entre la couche utile 10 et le substrat support 30. Notons que le film encapsulé 2' correspond au film 2 lorsque celui-ci n'a été déposé que sur l'une des faces libres à assembler 10a,30a, ou correspond aux deux films 2 déposés respectivement sur la couche utile 10 et sur le substrat support 30.

Le procédé de fabrication selon l'invention comprend ensuite une étape e) de recuit de la structure intermédiaire 150 à une température supérieure ou égale à une température critique, de manière à provoquer la segmentation du film encapsulé 2' sous forme d'agglomérats 21 et à former une zone d'interface 20 (figure 2e) comportant :
- des régions de contact direct 22 entre la couche utile 10 et le substrat support 30, autrement dit, des régions dans lesquelles il y a une liaison directe entre les matériaux semi-conducteurs de la couche utile 10 et du substrat support 30, et
- des agglomérats 21 comprenant le matériau semi-conducteur du film 2 (deuxième matériau), et présentant une épaisseur, selon un axe z normal au plan principal (x,y), faible voire très faible, à savoir inférieure ou égale à 250nm, inférieure ou égale à 50nm, inférieure ou égale à 40nm, inférieure ou égale à 30nm, inférieure ou égale à 20nm, voire inférieure ou égale à 10nm. Les agglomérats 21, répartis dans la zone d'interface 20, sont disjoints ou accolés ; les agglomérats 21 disjoints sont séparés les uns des autres par des régions de contact direct 22. Les régions de contact direct 22 et les agglomérats 21 sont adjacents dans le plan principal (x,y).

L'étape e) aboutit à la formation de la structure semi-conductrice 100.

On appelle température critique la température à partir de laquelle il va être énergétiquement plus favorable pour le deuxième matériau de former des agglomérats 21 plutôt que de rester sous forme de film encapsulé 2' très fin. La température de recuit de l'étape e) doit d'autre part être suffisante pour permettre le collage des régions de contact direct 22, entre les agglomérats 21. La température critique est typiquement comprise entre 500°C et 1800°C, selon la nature du deuxième matériau et du (ou des) matériau(x) semi-conducteur(s) de la couche utile 10 et du substrat support 30.

L'étape e) de recuit est donc toujours réalisée à une température supérieure ou égale à cette température critique, et sous atmosphère neutre, en particulier sous argon, argon/hydrogène ou azote.

Au-delà de la température critique, le système incluant le film encapsulé 2' et les surfaces semi-conductrices de la couche utile 10 et du substrat support 30 en contact avec ledit film 2', va optimiser son énergie de surface en segmentant le film encapsulé 2' sous forme d'agglomérats 21, et en créant des régions de contact direct 22 entre les surfaces semi-conductrices respectivement de la couche utile 10 et du substrat support 30.

Par ailleurs, parce que le film encapsulé 2' est extrêmement fin, des matériaux semi-conducteurs connus pour être stables à basse ou moyenne température seulement, peuvent être utilisés en tant que deuxième matériau dans des structures semi-conductrices 100 conformes à l'invention susceptibles de subir des traitements à hautes (900°C-1100°C), voire très hautes (1200°C-1900°C) températures. En effet, du fait de leur précipitation sous forme d'agglomérats 21 de faibles dimensions et de très faible épaisseur, ils ne provoquent pas de détérioration de la structure 100 et en particulier de la couche utile 10. On citera par exemple le cas d'agglomérats 21 comprenant du silicium dans une structure 100 comportant une couche utile 10 et un substrat support 30 en SiC et destinée à subir une épitaxie à une température comprise entre 1600°C et 1800°C. Notons que dans cet exemple, on observe une segmentation complète du film 2' en agglomérats 21, aux alentours de 1700°C.

Il est habituel qu'à l'étape a), la face libre 10a à assembler de la couche utile 10 comporte un oxyde natif et/ou, qu'à l'étape b), la face libre 30a à assembler du substrat support 30 comporte un tel oxyde. Le fait de ne pas avoir à gérer cet oxyde natif simplifie souvent les étapes de fabrication.

Ainsi, à l'étape e) du procédé selon l'invention, les agglomérats 21 de la zone d'interface 20 vont être à même de piéger l'oxygène issu du ou des oxyde(s) natif(s), et ainsi d'éliminer tout oxyde de l'interface entre la couche utile 10 et le substrat support 30, dans les régions de contact direct 22.

Par ailleurs, il est possible que les étapes c) et/ou d) du procédé soient opérées dans une atmosphère comprenant de l'oxygène, ce qui peut relâcher les contraintes de fabrication : de l'oxygène est alors présent à l'interface de collage 15 dans la structure intermédiaire 150.

Dans ce cas également, à l'étape e), les agglomérats 21 de la zone d'interface 20 vont piéger l'oxygène de l'interface de collage 15, évitant ainsi la présence d'oxygène dans les régions de contact direct 22.

Le procédé de fabrication tel que décrit permet donc d'obtenir une structure semi-conductrice 100 procurant une conduction électrique verticale et/ou un contact direct efficace entre la couche utile 10 et le substrat support 30, via la zone d'interface 20, grâce aux régions de contact direct 22 exemptes d'oxygène et/ou d'oxydes natifs. Les très fins agglomérats 21 sont constitués du deuxième matériau et éventuellement d'oxygène piégé sous forme d'oxyde principalement.

En général, les agglomérats 21 se présentent sous la forme :
- de premiers précipités comprenant le matériau semi-conducteur du film 2 (deuxième matériau), et/ou
- de deuxièmes précipités comprenant le deuxième matériau et de l'oxygène (principalement sous forme d'oxyde dudit deuxième matériau), et/ou
- de cavités dont les parois internes sont tapissées d'un composé comprenant le deuxième matériau et de l'oxygène (principalement sous forme d'oxyde dudit deuxième matériau).

La zone d'interface 20 avec les agglomérats 21, adjacents aux régions de contact direct 22, assure la tenue mécanique et plus généralement la fiabilité de la couche utile 10 et/ou des composants qui seront élaborés sur ou dans celle-ci.

La structure semi-conductrice 100 selon l'invention garantit une bonne conductivité électrique et/ou un contact direct efficace entre la couche utile 10 et le substrat support 30, via sa zone d'interface 20. En particulier, les agglomérats 21, répartis dans la zone d'interface 20, dans un plan médian P sensiblement parallèle au plan principal (x,y), sont aptes à piéger efficacement l'oxygène éventuellement présent dans le film encapsulé 2' ou à l'interface de collage 15 ; les régions de contact direct 22 entre la couche utile 10 et le substrat support 30, dépourvues de résidus d'oxyde natif notamment, autorisent une conduction électrique et/ou un contact semi-conducteur/semi-conducteur vertical efficace et de bonne qualité.

En outre, les agglomérats 21 et les régions de contact direct 22 assurent la continuité mécanique de la zone d'interface 20 et procurent une excellente tenue mécanique entre la couche utile 10 et le substrat support 30. La qualité de la couche utile 10 n'est donc pas affectée par d'éventuels trous ou défauts d'interface ; notons que les cavités précitées, lorsqu'elles sont présentes, ont des dimensions et une densité qui n'impactent pas négativement la qualité et la tenue de la couche utile 10.

En se plaçant dans un plan médian P de la zone d'interface 20, le taux de recouvrement des agglomérats 21 est typiquement compris entre 1% et 50%, préférentiellement entre 10% et 40%. Les dimensions latérales (dans le plan médian P) des agglomérats 21 sont limitées, typiquement de l'ordre de 5 nm à 500 nm. En particulier, lorsque l'épaisseur du film 2 déposé à l'étape c) est inférieure à 10 nm, les dimensions latérales des agglomérats 21 sont de l'ordre de 5 nm à 150 nm et l'épaisseur des agglomérats 21 est inférieure ou égale à 50 nm.

Parmi les agglomérats 21, les premiers précipités et les cavités peuvent présenter une forme lenticulaire ou polygonale, et les deuxièmes précipités peuvent présenter une forme sensiblement triangulaire, dans un plan transverse normal au plan principal (x,y).

### Exemple de mise en œuvre :

Le substrat donneur 1 est en SiC 4H, monocristallin de haute qualité et présente un diamètre de 150mm. Le substrat donneur 1 est dopé N, avec une résistivité de l'ordre de 20mohm.cm. Il est implanté à travers sa face avant 1a, face de type « C », avec des ions hydrogène à une dose de 5^{E}16/cm² et une énergie de 95keV. Autour de la profondeur d'implantation, un plan fragile enterré 11 est ainsi défini, délimitant avec la face avant 10a du substrat donneur 1, la couche utile 10.

Le substrat support 30 est en SiC 4H monocristallin de moindre qualité, de même diamètre que le substrat donneur 1. Il est dopé N, avec une résistivité de l'ordre de 20mohm.cm.

Les deux substrats 1,30 subissent des séquences de nettoyage, pour éliminer les particules et autres contaminations de surface. Les deux substrats peuvent comprendre un oxyde natif en surface.

Les substrats 1,30 sont introduits dans une première chambre de dépôt, intégrée à un équipement de collage direct. Un film 2 de silicium d'une épaisseur de 1nm est déposé sur chacune des faces avant 10a,30a (faces libres à assembler) des substrats 1,30, sous vide secondaire, à 10⁻⁶Pa et température ambiante, par pulvérisation.

Les substrats 1,30 sont introduits dans une seconde chambre de collage, pour être assemblés au niveau de leurs faces avant 10a,30a, en mettant en contact direct les films 2 déposés respectivement sur le substrat donneur 1 et sur le substrat support 30. L'atmosphère dans la chambre de collage est la même que celle dans la chambre de dépôt, mais pourrait éventuellement être différente : par exemple, les substrats peuvent être retirés de la première chambre, remis en atmosphère ambiante, puis introduits dans un équipement de collage dissocié de la chambre de dépôt. En effet, le procédé selon l'invention relaxe énormément les contraintes liées à la présence d'oxygène, par exemple sous forme d'oxyde natif, dans ou sur les films à assembler.

Après assemblage, l'ensemble collé 200 comprend le substrat donneur 1 lié au substrat support 30 via une interface de collage 15, et le film encapsulé 2' formé des deux films 2 déposés et enterré entre les deux substrats 1,30. Le film encapsulé 2' présente une épaisseur de l'ordre de 2nm.

L'ensemble collé 200 est soumis à un traitement thermique pour provoquer la séparation au niveau du plan fragile enterré 11, à une température d'environ 900°C, pendant 30 minutes. On obtient alors la structure intermédiaire 150 incluant une couche utile 10 présentant une épaisseur de 500nm, disposée sur le film encapsulé 2', lui-même disposé sur le substrat support 30. Des séquences de nettoyage et de polissage sont appliquées de manière à restaurer le bon niveau de défectivité et de rugosité à la surface 10b de la couche utile 10.

Enfin, un recuit à 1900°C pendant 30min est appliqué à la structure intermédiaire 150, préalablement munie d'une couche de protection sur sa face avant 10b (également face libre 10b de la couche utile 10 dans la structure intermédiaire 150). A l'issue de ce recuit, on obtient la structure 100 selon l'invention la zone d'interface 20 est formée avec des agglomérats 21 comprenant du silicium et de l'oxygène (principalement sous forme SiOx), séparés par des régions de contact direct 20 entre couche utile 10 et substrat support 30. Une telle zone d'interface 20 confèrent à la structure 100 une bonne conductivité électrique verticale, proche de celle d'un substrat SiC massif présentant une résistivité de 20mohm.cm.

La zone d'interface 20 présente une résistivité inférieure ou égale à 0,1 mohm.cm². Cela est apparent sur le graphe de la figure 4a qui illustre les courbes de courant en fonction de la tension I(V) pour des composants simples comprenant deux électrodes métalliques de contact 41,42, de tailles différentes (entre 50 microns et 230 microns de diamètre) ; ces tailles d'électrodes (motifs) sont reportées sur le graphe de la figure 4a. Dans le cas de la structure 100 selon l'invention, la mesure de I(V) est faite au niveau de deux électrodes 41,42 entre lesquelles le chemin de courant passe par la zone d'interface 20, du fait de la présence de tranchées 40, entre les électrodes 41,42, qui traversent ladite zone d'interface 20 (figure 4b). Une résistivité de la zone d'interface 20 de l'ordre de 0,0076 mohm.cm² a été extraite. Pour comparaison et référence, des électrodes 51,52 sont également déposées sur le substrat support 30 : les courbes I(V) associées sont notées « bulk » sur le graphe de la figure 4a.

Les agglomérats 21 dans cette structure 100 présentent une épaisseur de 5nm à 15nm et un diamètre moyen du même ordre de grandeur. Le taux de recouvrement des agglomérats 21, dans un plan médian P de la zone d'interface 20 est de l'ordre de 20%.

Il faut noter que des températures de recuit (étape e)), autres que 1900°C, ont également été appliquées à la structure intermédiaire 150 décrite dans l'exemple ci-dessus : par exemple 1370°C. Une résistivité de la zone d'interface 20 de l'ordre de 0,032 mohm.cm² a été extraite, soit nettement inférieure à 0,1 mohm.cm².

Bien sûr, cet exemple n'est pas limitatif et de nombreuses autres structures semi-conductrices 100 conformes à l'invention peuvent être élaborées, basées sur différentes combinaisons de matériaux pour la couche utile 10, le film 2 et le substrat support 30, en respectant les conditions énoncées précédemment pour la formation de la zone d'interface 20.

Des composants électroniques peuvent être élaborés sur et/ou dans la couche utile 10 d'une structure semi-conductrice 100 selon l'invention. Ces composants peuvent notamment adresser des applications de puissance, des applications photovoltaïques ou de diodes électroluminescentes.

Les composants peuvent comprendre au moins un contact électrique sur et/ou dans le substrat support 30, au niveau d'une face arrière 100b de la structure semi-conductrice 100, en particulier pour les applications de puissance. A titre d'exemples non limitatifs, ces composants de puissance pourront comprendre des transistors, des diodes, des thyristors ou des composants passifs (capacités, inductances...), etc.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'une structure semi-conductrice (100) comprenant les étapes suivantes :
a) la fourniture d'une couche utile (10) en un matériau semi-conducteur présentant une face libre (10a) à assembler,
b) la fourniture d'un substrat support (30) en un matériau semi-conducteur présentant une face libre (30a) à assembler,
c) le dépôt d'un film (2) composé d'un matériau semi-conducteur différent de celui ou ceux de la couche utile (10) et du substrat support (30), présentant une épaisseur inférieure à 50 nm, sur la face libre (10a) à assembler de la couche utile (10) et/ou sur la face libre (30a) à assembler du substrat support (30),
d) la formation d'une structure intermédiaire (150), comprenant un assemblage direct, le long d'une interface de collage (15) s'étendant selon un plan principal (x,y), des faces libres à assembler respectivement de la couche utile (10) et du substrat support (30), la structure intermédiaire (150) comprenant un film encapsulé (2') issu du ou des film(s) (2) déposés lors de l'étape c),
e) le recuit de la structure intermédiaire (150) à une température supérieure ou égale à une température critique, de manière à provoquer la segmentation du film encapsulé (2') et à former la structure semi-conductrice (100) comprenant une zone d'interface (20) entre la couche utile (10) et le substrat support (30), ladite zone d'interface (20) comportant :
- des régions de contact direct (22) entre la couche utile (10) et le substrat support (30), et
- des agglomérats (21) comprenant le matériau semi-conducteur du film (2), et présentant une épaisseur, selon un axe (z) normal au plan principal (x,y), inférieure ou égale à 250nm ; les régions de contact direct (22) et les agglomérats (21) étant adjacents dans le plan principal (x, y) .

2. Procédé de fabrication selon la revendication précédente, dans lequel :
- à l'étape a), la face libre (10a) à assembler de la couche utile (10) comporte un oxyde natif et/ou, à l'étape b), la face libre (30a) à assembler du substrat support (30) comporte un oxyde natif,
- à l'étape e), les agglomérats (21) de la zone d'interface (20) piègent l'oxygène issu du ou des oxyde(s) natif(s).

3. Procédé de fabrication selon l'une des revendications précédentes, dans lequel l'étape a) comprend une implantation d'espèces légères dans un substrat donneur (1), pour former un plan fragile enterré (11) qui délimite, avec une face avant (10a) du substrat donneur (1), la couche utile (10).

4. Procédé de fabrication selon la revendication précédente, dans lequel l'étape a) comprend la formation du substrat donneur (1), par épitaxie d'une couche donneuse (1') sur un substrat initial, l'implantation étant réalisée ultérieurement, dans la couche donneuse (1').

5. Procédé de fabrication selon l'une des deux revendications précédentes, dans lequel l'étape d) comprend, après l'assemblage direct donnant lieu à un ensemble collé (200) comprenant le substrat donneur (1) et le substrat support (30), une séparation au niveau du plan fragile enterré (11), pour former d'une part la structure intermédiaire (150) comprenant la couche utile (10), le film encapsulé (2') et le substrat support (30), et d'autre part, le reste du substrat donneur (1").

6. Procédé de fabrication selon l'une des revendications précédentes, dans lequel l'épaisseur du film déposé (2) à l'étape c) est inférieure ou égale à 10nm, voire inférieure ou égale à 5 nm, voire inférieure ou égale à 3 nm, voire inférieure ou égale à 2nm.

7. Procédé de fabrication selon la revendication précédente, dans lequel l'épaisseur du film déposé (2) à l'étape c) est inférieure à 10nm, et les agglomérats (21) présentent une épaisseur, selon un axe (z) normal au plan principal (x,y), inférieure ou égale à 50nm.

8. Procédé de fabrication selon l'une des revendications précédentes, dans lequel la température critique est comprise entre 500°C et 1800°C, selon la nature du matériau semi-conducteur du film (2) et du (ou des) matériau (x) semi-conducteur(s) de la couche utile (10) et du substrat support (30) .

9. Procédé de fabrication selon l'une des revendications précédentes, dans lequel le matériau semi-conducteur de la couche utile (10) est le carbure de silicium et présente une structure monocristalline, poly-cristalline ou amorphe.

10. Procédé de fabrication selon l'une des revendications précédentes, dans lequel le matériau semi-conducteur du substrat support (30) est le carbure de silicium et présente une structure monocristalline, poly-cristalline ou amorphe.

11. Procédé de fabrication selon l'une des revendications précédentes, dans lequel le matériau semi-conducteur du film (2) est choisi parmi le silicium ou le germanium.

12. Procédé de fabrication selon l'une des revendications précédentes, dans lequel les agglomérats (21) présentent une épaisseur inférieure ou égale à 40 nm, voire inférieure ou égale à 30nm.

13. Procédé de fabrication selon l'une des revendications précédentes, dans lequel les agglomérats (21) se présentent sous la forme :
- de premiers précipités comprenant le matériau semi-conducteur du film (2),
- de deuxièmes précipités comprenant le matériau semi-conducteur du film (2) et de l'oxygène, et/ou
- de cavités tapissées d'un composé comprenant le matériau semi-conducteur du film (2) et de l'oxygène.

14. Procédé de fabrication selon la revendication précédente, dans lequel les deuxièmes précipités présentent une forme sensiblement triangulaire dans un plan transverse normal au plan principal (x,y).

15. Composant électronique élaboré sur et/ou dans une couche utile (10) d'une structure semi-conductrice (100) issue du procédé de fabrication selon l'une des revendications précédentes, la structure semi-conductrice (100) comprenant :
- la couche utile (10) en un matériau semi-conducteur, s'étendant selon un plan principal (x,y),
- un substrat support (30) en un matériau semi-conducteur,
- et une zone d'interface (20) entre la couche utile (10) et le substrat support (30), s'étendant parallèlement au plan principal (x,y), la zone d'interface (20) comportant des régions de contact direct (22) entre la couche utile (10) et le substrat support (30), et des agglomérats (21), comprenant un matériau semi-conducteur différent de celui ou ceux de la couche utile (10) et du substrat support (30), et présentant une épaisseur, selon un axe (z) normal au plan principal (x,y), inférieure ou égale à 250nm ; les régions de contact direct (22) et les agglomérats (21) étant adjacents dans le plan principal (x,y).

16. Composant électronique selon la revendication précédente, comprenant au moins un contact électrique sur et/ou dans le substrat support (30), au niveau d'une face arrière de la structure semi-conductrice (100) pour une application de puissance.

## Patentansprüche

1. Herstellungsverfahren einer Halbleiterstruktur (100), umfassend die folgenden Schritte:
a) Bereitstellen einer Nutzschicht (10) aus einem Halbleitermaterial, die eine zusammenzufügende freie Fläche (10a) aufweist,
b) Bereitstellen eines Trägersubstrats (30) aus einem Halbleitermaterial, das eine zusammenzufügende freie Fläche (30a) aufweist,
c) Aufbringen einer Folie (2), die aus einem Halbleitermaterial gebildet ist, das sich von dem oder denen der Nutzschicht (10) und dem Trägersubstrat (30) unterscheidet, die eine Dicke von weniger als 50 nm aufweist, auf der zusammenzufügenden freien Fläche (10a) der Nutzschicht (10) und/oder auf der zusammenzufügenden freien Fläche (30a) des Trägersubstrats (30),
d) Ausbilden einer Zwischenstruktur (150), umfassend eine direkte Zusammenfügung, entlang einer Klebverbindungsfläche (15), die sich entlang einer Hauptebene (x,y) der freien zusammenzufügenden Flächen jeweils der Nutzschicht (10) und des Trägersubstrats (30)erstreckt, die Zwischenstruktur (150) umfassend eine eingekapselten Folie (2'), die aus der Folie /den Folien (2) stammt, die während Schritt c) abgeschieden werden,
e) Glühen der Zwischenstruktur (150) bei einer Temperatur von größer als oder gleich einer kritischen Temperatur, um die Segmentierung der eingekapselten Folie (2') zu bewirken und zum Ausbilden der Halbleiterstruktur (100), umfassend einen Verbindungsflächenbereich (20) zwischen der Nutzschicht (10) und dem Trägersubstrat (30), wobei der Verbindungsflächenbereich (20) vorweist:
- direkte Kontaktregionen (22) zwischen der Nutzschicht (10) und dem Trägersubstrat (30), und
- Gemische (21), umfassend das Halbleitermaterial der Folie (2), und die eine Dicke entlang einer Achse (z), die senkrecht zu der Hauptebene (x,y) ist, von weniger als oder gleich 250 nm aufweisen; wobei die direkten Kontaktregionen (22) und die Gemische (21) in der Hauptebene (x,y) benachbart sind.

2. Herstellungsverfahren nach dem vorstehenden Anspruch, wobei:
- in Schritt a) die zusammenzufügende freie Fläche (10a) der Nutzschicht (10) ein natives Oxid vorweist und/oder in Schritt b) die zusammenzufügende freie Fläche (30a) des Trägersubstrats (30) ein natives Oxid vorweist,
- in Schritt e) die Gemische (21) des Verbindungsflächenbereichs (20) den Sauerstoff, der aus dem nativen oder den nativen Oxid(en) stammt, einfangen.

3. Herstellungsverfahren nach einem der vorstehenden Ansprüche, wobei Schritt a) eine Implantation von leichten Spezies in ein Spendersubstrat (1) umfasst, zum Ausbilden einer unterirdischen fragilen Ebene (11), die mit einer vorderen Fläche (10a) des Spendersubstrats (1) die Nutzschicht (10) begrenzt.

4. Herstellungsverfahren nach dem vorstehenden Anspruch, wobei Schritt a) die Ausbildung des Spendersubstrats (1) durch Epitaxie einer Spenderschicht (1') auf einem Ausgangssubstrat umfasst, wobei die Implantation in der Spenderschicht(1') anschließend durchgeführt wird.

5. Herstellungsverfahren nach einem der zwei vorstehenden Ansprüche, wobei Schritt d) nach der direkten Zusammenfügung, die eine verklebte Anordnung (200) verursacht, umfassend das Spendersubstrat (1) und das Trägersubstrat (30), eine Trennung an der unterirdischen fragilen Ebene (11), zum Ausbilden eines Teils der Zwischenstruktur (150), umfassend die Nutzschicht (10), die eingekapselte Folie (2') und das Trägersubstrat (30) und andererseits den Rest des Spendersubstrats (1").

6. Herstellungsverfahren nach einem der vorstehenden Ansprüche, wobei die Dicke der in Schritt c) abgeschiedenen Folie (2) kleiner als oder gleich 10 nm, sogar kleiner als oder gleich 5 nm, sogar kleiner als oder gleich 3 nm, sogar kleiner als oder gleich 2 nm, ist.

7. Herstellungsverfahren nach dem vorstehenden Anspruch, wobei die Dicke der in Schritt c) abgeschiedenen Folie (2) kleiner als 10 nm ist, und die Gemische (21) eine Dicke entlang einer Achse (z), die senkrecht zu der Hauptebene (x,y) ist, von kleiner als oder gleich 50 nm aufweisen.

8. Herstellungsverfahren nach einem der vorstehenden Ansprüche, wobei die kritische Temperatur zwischen 500 °C und 1800 °C liegt, gemäß der Art des Halbleitermaterials der Folie (2) und dem (oder den) Halbleitermaterial(ien) der Nutzschicht (10) und des Trägersubstrats(30).

9. Herstellungsverfahren nach einem der vorstehenden Ansprüche, wobei das Halbleitermaterial der Nutzschicht (10) Siliziumkarbid ist und eine monokristalline, polykristalline oder amorphe Struktur aufweist.

10. Herstellungsverfahren nach einem der vorstehenden Ansprüche, wobei das Halbleitermaterial des Trägersubstrats (30) Siliziumkarbid ist und eine monokristalline, polykristalline oder amorphe Struktur aufweist.

11. Herstellungsverfahren nach einem der vorstehenden Ansprüche, wobei das Halbleitermaterial der Folie (2) aus Silizium oder Germanium ausgewählt ist.

12. Herstellungsverfahren nach einem der vorstehenden Ansprüche, wobei die Gemische (21) eine Dicke von kleiner als oder gleich 40 nm, sogar kleiner als oder gleich 30 nm, aufweisen.

13. Herstellungsverfahren nach einem der vorstehenden Ansprüche, wobei die Gemische (21) in der Form auftreten:
- von ersten Präzipitaten, umfassend das Halbleitermaterial der Folie (2),
- von zweiten Präzipitaten, umfassend das Halbleitermaterial der Folie (2) und Sauerstoff, und/oder
- von Hohlräumen, ausgekleidet mit einer Zusammensetzung, umfassend das Halbleitermaterial der Folie (2) und Sauerstoff.

14. Herstellungsverfahren nach dem vorstehenden Anspruch, wobei die zweiten Präzipitate eine Form aufweisen, die im Wesentlichen dreieckig in einer Querebene ist, die senkrecht zu der Hauptebene (x,y) ist.

15. Elektronisches Bauteil, das auf und/oder in einer Nutzschicht (10) einer Halbleiterstruktur (100) gefertigt ist, die aus dem Herstellungsverfahren nach einem der vorstehenden Ansprüche stammt, die Halbleiterstruktur (100) umfassend:
- die Nutzschicht (10) aus einem Halbleitermaterial, die sich entlang einer Hauptebene (x,y) erstreckt,
- ein Trägersubstrat (30) aus einem Halbleitermaterial,
- und ein Verbindungsflächenbereich (20) zwischen der Nutzschicht (10) und dem Trägersubstrat (30), der sich parallel zu der Hauptebene (x,y) erstreckt, wobei der Verbindungsflächenbereich (20) Direktkontaktregionen (22) zwischen der Nutzschicht (10) und dem Trägersubstrat (30), und Gemische (21), umfassend ein Halbleitermaterial, das sich von dem oder denen der Nutzschicht (10) und dem Trägersubstrat (30) unterscheidet, vorweist, und eine Dicke aufweist, die entlang einer Achse (z) senkrecht zu der Hauptebene (x,y), kleiner als oder gleich 250 nm ist; wobei die Direktkontaktregionen (22) und die Gemische (21) in der Hauptebene (x,y) benachbart sind.

16. Elektronisches Bauteil nach dem vorstehenden Anspruch, umfassend mindestens einen elektrischen Kontakt auf und/oder in dem Trägersubstrat (30), an einer hinteren Fläche der Halbleiterstruktur (100) für eine Leistungsanwendung.

## Claims

1. Method for producing a semiconductor structure (100) comprising the following steps:
a) providing a working layer (10) made of a semiconductor material having a free face (10a) to be joined,
b) providing a carrier substrate (30) made of a semiconductor material having a free face (30a) to be joined,
c) depositing a film (2) composed of a semiconductor material different from that or those of the working layer (10) and of the carrier substrate (30), having a thickness of less than 50 nm, on the free face (10a) to be joined of the working layer (10) and/or on the free face (30a) to be joined of the carrier substrate (30),
d) forming an intermediate structure (150), comprising directly joining, along a bonding interface (15) extending along a main plane (x,y), the free faces to be joined of the working layer (10) and of the carrier substrate (30), respectively, the intermediate structure (150) comprising an encapsulated film (2') originating from the one or more film(s) (2) deposited during step c),
e) annealing the intermediate structure (150) at a temperature higher than or equal to a critical temperature, so as to bring about segmentation of the encapsulated film (2') and form the semiconductor structure (100) comprising an interface region (20) between the working layer (10) and the carrier substrate (30), said interface region (20) comprising:
- areas (22) of direct contact between the working layer (10) and the carrier substrate (30), and
- agglomerates (21) comprising the semiconductor material of the film (2), and having a thickness, along an axis (z) normal to the main plane (x,y), of less than or equal to 250 nm; the areas (22) of direct contact and the agglomerates (21) being adjacent in the main plane (x,y).

2. Production method according to the preceding claim, wherein:
- in step a), the free face (10a) to be joined of the working layer (10) comprises a native oxide and/or, in step b), the free face (30a) to be joined of the carrier substrate (30) comprises a native oxide,
- in step e), the agglomerates (21) of the interface region (20) trap the oxygen originating from the native oxide(s).

3. Production method according to one of the preceding claims, wherein step a) comprises an implantation of light species in a donor substrate (1), to form a buried fragile plane (11) which delimits, with a front face (10a) of the donor substrate (1), the working layer (10).

4. Production method according to the preceding claim, wherein step a) comprises the formation of the donor substrate (1) by epitaxy of a donor layer (1') on an initial substrate, the implantation being carried out subsequently, in the donor layer (1').

5. Production method according to one of the two preceding claims, wherein step d) comprises, after the direct assembly giving rise to a bonded assembly (200) comprising the donor substrate (1) and the carrier substrate (30), a separation at the buried fragile plane (11), in order to form the intermediate structure (150) comprising the working layer (10), the encapsulated film (2') and the carrier substrate (30), and to form the remainder of the donor substrate (1").

6. Production method according to one of the preceding claims, wherein the thickness of the deposited film (2) in step c) is less than or equal to 10 nm, or less than or equal to 5 nm, or less than or equal to 3 nm, or less than or equal to 2 nm.

7. Production method according to the preceding claim, wherein the thickness of the deposited film (2) in step c) is less than 10 nm, and the agglomerates (21) have a thickness, along an axis (z) normal to the main plane (x,y), of less than or equal to 50 nm.

8. Production method according to one of the preceding claims, wherein the critical temperature is between 500°C and 1,800°C, depending on the nature of the semiconductor material of the film (2) and of the semiconductor material(s) of the working layer (10) and of the carrier substrate (30).

9. Production method according to one of the preceding claims, wherein the semiconductor material of the working layer (10) is silicon carbide and has a monocrystalline, polycrystalline or amorphous structure.

10. Production method according to one of the preceding claims, wherein the semiconductor material of the carrier substrate (30) is silicon carbide and has a monocrystalline, polycrystalline or amorphous structure.

11. Production method according to one of the preceding claims, wherein the semiconductor material of the film (2) is chosen from silicon or germanium.

12. Production method according to one of the preceding claims, wherein the agglomerates (21) have a thickness of less than or equal to 40 nm, or less than or equal to 30 nm.

13. Production method according to one of the preceding claims, wherein the agglomerates (21) are in the form of:
- first precipitates comprising the semiconductor material of the film (2),
- second precipitates comprising the semiconductor material of the film (2) and oxygen, and/or
- cavities lined with a compound comprising the semiconductor material of the film (2) and oxygen.

14. Production method according to the preceding claim, wherein the second precipitates have a substantially triangular shape in a transverse plane normal to the main plane (x,y).

15. Electronic component produced on and/or in a working layer (10) of a semiconductor structure (100) resulting from the production method according to one of the preceding claims, the semiconductor structure (100) comprising:
- the working layer (10) made of a semi-conductor material, extending in a main plane (x,y),
- a carrier substrate (30) made of a semiconductor material,
- and an interface region (20) between the working layer (10) and the carrier substrate (30), extending parallel to the main plane (x,y), the interface region (20) comprising areas (22) of direct contact between the working layer (10) and the carrier substrate (30), and agglomerates (21), comprising a semiconductor material different from that or those of the working layer (10) and of the carrier substrate (30), and having a thickness, along an axis (z) normal to the main plane (x,y), of less than or equal to 250 nm; the areas (22) of direct contact and the agglomerates (21) being adjacent in the main plane (x,y).

16. Electronic component according to the preceding claim, comprising at least one electrical contact on and/or in the carrier substrate (30), at a rear face of the semiconductor structure (100) for a power application.
